# EUROPÄISCHE PATENTSCHRIFT

(11) **EP 0 780 972 B1**
(45) Veröffentlichungstag und Bekanntmachung des Hinweises auf die Patenterteilung: **22.03.2000**
(21) Anmeldenummer: 96119870.2
(22) Anmeldetag: 11.12.1996
(51) Int. Cl.: H03G 1/00

(54) **Universalverstärker**
Universal amplifier
Amplificateur universel

(30) Priorität: 22.12.1995 DE 19548434
(43) Veröffentlichungstag der Anmeldung: 25.06.1997
(73) Patentinhaber: Richard Hirschmann GmbH & Co., 72654 Neckartenzlingen (DE)
(72) Erfinder: Wendel, Wolfgang, Dipl.-Ing, 73257 Köngen (DE); Maier, Hartmut, 73760 Ostfildern (DE)
(74) Vertreter: Geyer, Ulrich F., Dr. Dipl.-Phys.

(56) Entgegenhaltungen:
- DE-C- 4 010 001
- GB-A- 2 161 335
- GB-A- 2 219 702
- US-A- 4 048 576
- US-A- 4 132 957
- US-A- 5 374 895
- PATENT ABSTRACTS OF JAPAN vol. 5, no. 163 (E-078), 20.Oktober 1991 & JP 56 090611 A (IWATSU ELECTRIC), 22.Juli 1981,

## Beschreibung

Die vorliegende Erfindung bezieht sich auf Verstärker und insbesondere auf Universalverstärker mit einem Eingang und einem Ausgang und mit mindestens einer Verstärkerstufe.

In Kabelfernsehnetzen werden Breitbandverstärker zum Ausgleich von Dämpfungen mit verschiedenen Verstärkungswerten benötigt. Diese Verstärker können mehrstufig aufgebaut sein und besitzen zur Einpegelung einen Dämpfungs- oder Pegelsteller am Eingang. Für niedrigere Pegel muß das Signal bei Breitbandverstärkern am Eingang stark gedämpft werden, um am Ausgang das gewünschte Signal zu erhalten. Um mit wenig Dämpfung am Eingang des Verstärkers auszukommen, werden in der Praxis Verstärkertypen mit unterschiedlichen Verstärkungswerten benötigt. Durch Vorauswahl des Verstärkertyps bzw. Verstärkerwerts wird eine gewisse Anpassung an den geforderten Verstärkungsgrad vorgenommen. Bei Eintakt-Verstärkern werden entsprechend der möglichen Transistor-Verstärkerstufen Verstärker mit Dämpfungen von 10 dB (einstufig), 20 dB (zweistufig) und 30 dB (dreistufig) eingesetzt. Die Feinjustierung erfolgt mit einem eingebauten Pegelsteller am Eingang des jeweiligen Verstärkers. Gegentakt-Hybridverstärker werden zur Erreichung höherer Ausgangspegel eingesetzt. Die Gegentakt-Hybridverstärker weisen zum Teil noch höhere Verstärkungen, beispielsweise 34 oder 38 dB, auf.

Die vielen benötigten Verstärker bedingen in der Praxis eine hohe Lagerhaltung und einen hohen Handhabungsaufwand, da oft ein Verstärker mit dem benötigten Verstärkungswert gerade nicht verfügbar ist.

Es ist daher ein Ziel der vorliegenden Erfindung, einen Universalverstärker vorzusehen, mit dem das Geräteprogramm gestrafft werden kann und möglichst wenig Verstärkertypen ausreichen, ohne daß die Rauschwerte des Verstärkers verschlechtert werden.

Diese Aufgabe wird erfindungsgemäß gelöst durch die Merkmale des Anspruchs 1.

Durch Kombination verschiedener Verstärkerstufen und/oder Dämpfungsglieder mit einer Hauptverstärkerstufe lassen sich verschiedene Verstärkungswerte für den gesamten Verstärker erreichen.

Durch die Typenreduzierung wird die Logistik stark vereinfacht, der schaltungstechnische Mehraufwand wird durch die höheren Losgrößen bzw. Stückzahlen in der Fertigung und Disposition mehr als kompensiert, so daß diese Lösung insgesamt wirtschaftlicher ist. Für den Kunden bedeutet dies, daß er seine Lagerhaltung minimieren und seinen benötigten Verstärkungsgrad vor Ort, d. h. in der realen Anlage, speziell einstellen kann. Bei einer späteren Erweiterung oder Änderung der Anlage kann der Verstärker einfach und ohne Aufwand den neuen Gegebenheiten angepaßt werden. So kann beispielsweise bei Erweiterung der Anlage, sofern Verstärkungreserven unsprünglich eingeplant wurden, flexibel durch Hinzuschalten einer weiteren, bereits vorhandenen Verstärkerstufe reagiert werden, ohne den Verstärker tauschen zu müssen.

Um die Rauschwerte oder -zahlen des Verstärkers nicht zu verschlechtern, werden jeweils gesamte Verstärkerstufen und/oder Dämpfungsglieder hinzu- und abgeschaltet. Die Kaskadierfähigkeit ist dadurch unverändert gegeben.

Patent Abstracts of Japan, vol. 5, no. 163 (E-078) offenbart eine Schaltung, in der Verstärkerstufen hinzu- und abgeschaltet werden, wobei US-A-5,374,895 (Lee et al.) eine Schaltung offenbart, in der ein Dämpfungsglied hinzu- und abgeschaltet wird.

Gemäß der Erfindung wird die Stromversorgung der geschalteten Verstärkerstufen mit umgeschaltet. Die Stromversorgungspfade der geschalteten Verstärkerstufen werden mit umgeschaltet, um den Strombedarf bei nicht benötigter Verstärkerstufe zu reduzieren und die Stabilität zu erhöhen.

Gemäß einer weiteren vorteilhaften Ausgestaltung der Erfindung erfolgt die Stromversorgung der Verstärkerstufen über einen durch den Universalverstärker verlaufenden Signalpfad, wobei eine Gleichstromquelle vorgesehen ist, wobei jeweils eine Drossel zwischen dem Signalpfad und der Gleichstromquelle einerseits und zwischen dem Signalpfad und einem Versorgungsanschluß der Verstärkerstufen andererseits geschaltet ist, und wobei am Eingang und am Ausgang des Universalverstärkers jeweils ein Kondensator vorgesehen ist. Dadurch kann die Umschaltung besonders leicht durch einpolige Umschalter erreicht werden.

Gemäß einer weiteren vorteilhaften Ausgestaltung der Erfindung können die Umschalter als Steckbrücken ausgeführt sein.

Gemäß einer weiteren vorteilhaften Ausgestaltung der Erfindung ist am Eingang des Universalverstärkers ein Pegelsteller/Entzerrer zur Feineinstellung vorgesehen.

Gemäß einer weiteren vorteilhaften Ausgestaltung der Erfindung ist das Dämpfungsglied ein π-Glied.

Weitere Einzelheiten und Merkmale der vorliegenden Erfindung ergeben sich aus der folgenden Beschreibung eines Ausführungsbeispiels der Erfindung anhand der Zeichnung; in der Zeichnung zeigt:
- Fig. 1: einen schematischen Schaltplan eines Ausführungsbeispiels als dreistufigem Verstärker;
- Fig. 2: einen Schaltplan eines weiteren Ausführungsbeispiels der Erfindung, bei dem ein Dämpfungsglied hinzu- oder abgeschaltet wird.

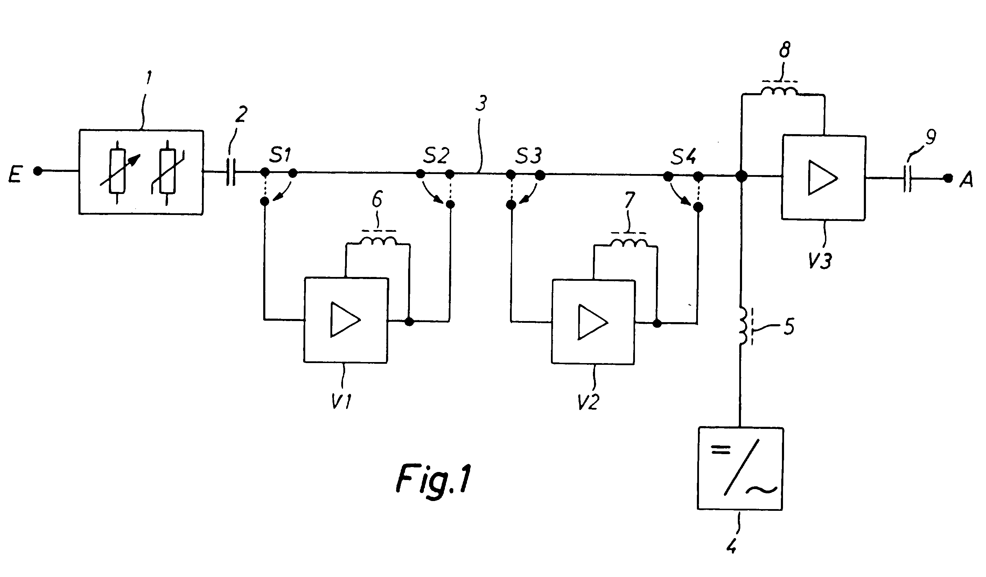

Zuerst wird das Ausführungsbeispiel gemäß Fig. 1 beschrieben. Mit dem Signaleingang E ist ein Pegelsteller und Entzerrer 1 zur Feineinstellung bzw. zum Feinabgleich verbunden. Der Pegelsteller/Entzerrer 1 ist an seinem Ausgang mit einem Kondensator 2 verbunden, welcher zur Gleichstromentkoppelung vorgesehen ist. Anhand von Umschaltern S1 und S2 bzw. S3 und S4, die vorteilhafterweise als Steckbrücken ausgestaltet sind, werden wahlweise eine oder zwei Verstärkerstufen V1 und V2 in den mit 3 bezeichneten Signalpfad hineingeschaltet, wobei die Stromversorgungspfade der geschalteten Verstärkerstufen mit umgeschaltet werden. Eine dritte Verstärkerstufe V3 ist ständig in den Signalpfad geschaltet, um eine Grundverstärkung des Verstärkers zu gewährleisten.

Die Stromversorgung erfolgt über eine Gleichstromquelle 4, vorzugsweise einen an das Netz angeschlossenen Transformator mit nachgeschaltetem Gleichrichter. Zur wechselspannungsmäßigen Entkopplung der Stromversorgung (Gleichstromquelle 4) vom Signalpfad 3 ist dazwischen eine Drossel 5 vorgesehen. Ebenfalls zur wechselspannungsmäßigen Entkopplung ist zwischen dem Signalpfad 3 und jedem Versorgungsanschluß der Verstärkerstufen V1 bis V3 jeweils eine Drossel 6 bzw. 7 bzw. 8 vorgesehen.

Zwischen dem Ausgang der Verstärkerstufe V3 und dem Ausgang A des gesamten Verstärkers ist ein Kondensator 9 zur gleichspannungsmäßigen Entkopplung geschaltet. Der Kondensator 9 könnte alternativ aber auch direkt vor den Eingang der Verstärkerstufe V3 geschaltet werden.

Durch Hinzuschalten bzw. Abschalten der Verstärkerstufen V1 und/oder V2 lassen sich somit die folgenden Verstärkungskombinationen mit einem Verstärker realisieren:
V3
V1 + V3
V2 + V3
V1 + V2 + V3

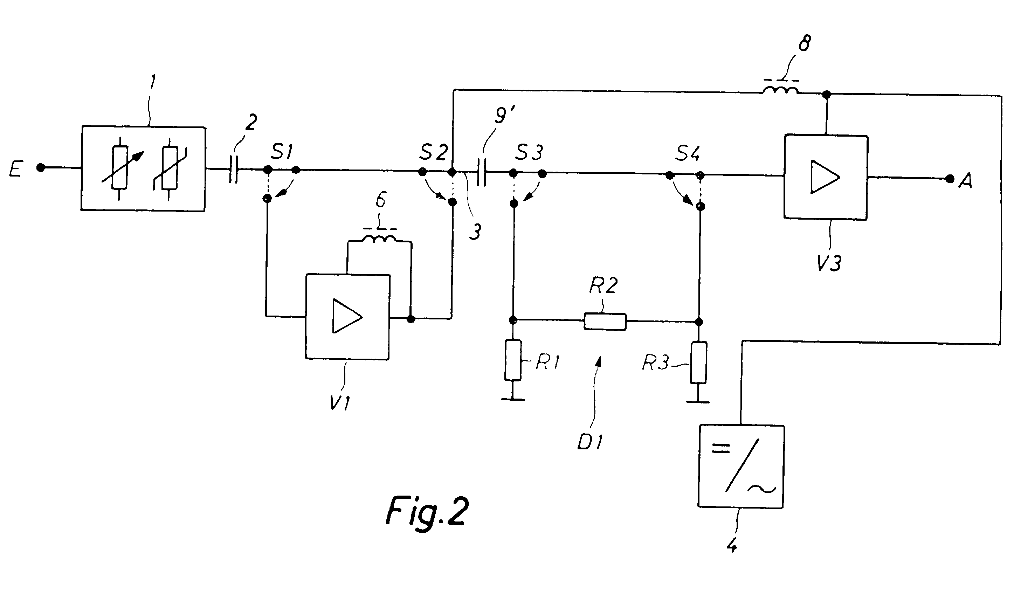

Das Ausführungsbeispiel gemäß Fig. 2 unterscheidet sich von dem in Fig. 1 gezeigten Ausführungsbeispiel darin, daß das Verstärkungsglied V2 mit der zugehörigen Drosselspule 7 ersetzt wurde durch ein Dämpfungsglied D1, das im vorliegenden Falle als ein π-Glied, bestehend aus drei Widerständen R1 bis R3, ausgebildet ist.

Um das Dämpfungsglied D1 aus dem Stromversorgungspfad für die Verstärkungsglieder auszuschließen, sind die Kondensatoren und Drosseln sowie die Stromversorgung entsprechend anders geschaltet. So ist in diesem Falle ein Entkoppelungskondensator 9' in den Signalpfad 3 zwischen die Umschalter S2 und S3 geschaltet, wobei dann auf den oben beschriebenen Kondensator 9 im Anschluß an das Verstärkungsglied V3 verzichtet wird. Ferner ist die Stromversorgung 4 nicht über die Drossel 5 an einer Stelle zwischen dem Umschalter S4 und dem Verstärkungsglied V3 mit dem Signalpfad 3 verbunden, sondern ist direkt mit dem Versorgungseingang des Verstärkerglieds V3 verbunden, welcher ferner, wie im vorhergehenden Ausführungsbeispiel, mit einem Anschluß der Drossel 8 verbunden ist. Der andere Anschluß der Drossel 8 ist dann an einer Stelle zwischen dem Umschalter S2 und dem Kondensator 9' mit dem Signalpfad 3 verbunden.

Falls ausschließlich Dämpfungsglieder hinzu- und abgeschaltet werden sollen, kann natürlich auf die Entkoppelungskondensatoren sowie auf die Drosseln verzichtet werden, wobei dann die Gleichstromquelle 4 direkt und ausschließlich an den Versorgungsanschluß der einzig verbleibenden Verstärkerstufe V3 angeschlossen wird.

Abwandlungen und Modifikationen der Erfindung sind im Rahmen des durch die Ansprüche definierten Schutzumfangs möglich. Insbesondere ist die Erfindung nicht auf einen dreistufigen Verstärker beschränkt. Ferner ist jede Kombination aus hinzu- und abschaltbaren Verstärkungs- und Dämpfungsgliedern zur Anpassung der Gesamtverstärkung der Verstärkers möglich.

## Patentansprüche

1. Verstärker mit einem Signalpfad von einem Eingang (E) zu einem Ausgang (A), mit mindestens einer Verstärkerstufe (V3), mindestens einer weiteren Verstärkerstufe (V1, V2) sowie signalführenden Umschaltern (S1 bis S4) in dem Signalpfad (3) zum Hineinschalten und Herausschalten der weiteren Verstärkerstufe (V1, V2) in den bzw. aus dem Signalpfad (3), dadurch gekennzeichnet, daß die Umschalter (S1 bis S4) zum Hinzuschalten und Abschalten der Stromversorgung der jeweiligen Verstärkerstufen (V1, V2) vorgesehen sind.

2. Verstärker nach Anspruch 1, dadurch gekennzeichnet, daß wenigstens ein hinsichtlich des Signalpfads hinein- bzw. herausschaltbares Dämpfungsglied (D1) vorgesehen ist.

3. Verstärker gemäß Anspruch 1 oder 2, dadurch gekennzeichnet, daß zur Stromversorgung der Verstärkerstufen (V1 bis V3) über einen durch den Verstärker verlaufenden Signalpfad (3) eine Gleichstromquelle (4) vorgesehen ist, wobei jeweils eine Drossel (5 bis 8) zwischen dem Signalpfad (3) und der Gleichstromquelle (4) einerseits und zwischen dem Signalpfad (3) und einem Versorgungsanschluß der jeweiligen Verstärkerstufen (V1 bis V3) andererseits geschaltet ist, und wobei am Eingang (E) und am Ausgang (A) jeweils ein Kondensator (2, 9) vorgesehen ist.

4. Verstärker gemäß einem der vorhergehenden Ansprüche, dadurch gekennzeichnet, daß am Eingang (E) ein Pegelsteller/Entzerrer (1) zur Feineinstellung vorgesehen ist.

5. Verstärker gemäß einem der vorheregehenden Ansprüche, dadurch gekennzeichnet, daß der oder die Umschalter (S1 bis S4) als Steckbrücken ausgeführt sind.

6. Verstärker gemäß einem der vorhergehenden Ansprüche, dadurch gekennzeichnet, daß das Dämpfungsglied (D1) ein π-Glied ist.

## Claims

1. Amplifier with a signal path from an input (I) to an output (O) with at least one amplifying stage (V3), at least one additional amplifying stage (V1, V2), as well as signal bearing change-over switches (S1 to S4) within the signal path (3) to add-in and to remove the further amplifying stages (V1, V2) into or out of the signal path (3), said amplifier **characterized in that**
the change-over switches (S1 to S4) are provided to add-in or switch-off the power supply of the respective amplifying stages (V1, V2).

2. Amplifier according to Claim 1 **characterized in that** with respect to the signal path at least one addable or removeable attenuation member (D1) is provided.

3. Amplifier according to Claim 1 or 2, **characterized in that** for the power supply of the amplifying stages (V1 to V3) over a signal path (3) running through an amplifier a DC power supply (4) is provided, wherein a solenoid (5 to 8) is added-in between the signal path (3) and the DC power supply (4) as well as between the signal path (3) and the supply connections of the respective amplifying stages (V1 to V3), and wherein a capacitor (2, 9) is provided at the input (I) and the output (O), respectively.

4. Amplifier according to one of the preceding claims **characterized in that** a level controller/equalizer (1) for fine tuning is provided at the output (O).

5. Amplifier according to one of the preceding claims **characterized in that** the one or the plurality of change-over switches (S1 to S4) are embodied as plug-in bridges.

6. Amplifier according to one of the preceding claims **characterized in that** the attenuation member (D1) is π-member.

## Revendications

1. Amplificateur présentant un trajet de signaux provenant d'une entrée (E) et d'une sortie (A) comportant au moins un étage d'amplification (V3), au moins un autre étage d'amplification (V1, V2) ainsi qu'un commutateur (S1 à S4) conduisant les signaux dans le trajet des signaux (3) pour commander l'entrée et la sortie de l'autre étage d'amplification (V1, V2) respectivement dans et du trajet des signaux (3), caractérisé en ce que les commutateurs (S1 à S4) sont prévus pour la mise en circuit et la mise hors circuit de l'alimentation électrique des étages d'amplification (V1, V2) respectifs.

2. Amplificateur selon la revendication 1, caractérisé en ce qu'il est prévu au moins un atténuateur (D1) qui peut être commandé de manière à se trouver dans le trajet des signaux ou à l'extérieur de celui-ci.

3. Amplificateur selon la revendication 1 ou 2, caractérisé en ce qu'il est prévu une source de courant continu (4) pour l'alimentation électrique des étages d'amplification (V1 à V3), par l'intermédiaire d'un trajet des signaux (3) passant par l'amplificateur, une bobine d'étranglement (5 à 8) étant montée d'une part entre le trajet des signaux (3) et la source de courant continu (4) et d'autre part entre le trajet des signaux (3) et une borne d'alimentation des étages d'amplification (V1 à V3) respectifs, et un condensateur (2, 9) étant prévu à l'entrée (E) à la sortie (A).

4. Amplificateur selon l'une des revendications précédentes, caractérisé en ce qu'un sélecteur de niveau/correcteur (1) est prévu à l'entrée (E) pour le réglage fin.

5. Amplificateur selon l'une des revendications précédentes, caractérisé en ce que le ou les commutateur(s) (S1 à S4) est ou sont réalisé(s) sous la forme de ponts à fiches.

6. Amplificateur selon l'une des revendications précédentes, caractérisé en ce que l'atténuateur (D1) est un élément en π.
